# EUROPÄISCHE PATENTSCHRIFT

(11) **EP 3 475 037 B1**
(45) Veröffentlichungstag und Bekanntmachung des Hinweises auf die Patenterteilung: **15.04.2020**
(21) Anmeldenummer: 17739494.7
(22) Anmeldetag: 26.06.2017
(51) Int. Cl.: B25J 15/00, B25J 15/02, B65H 67/06, H05K 13/02, H05K 13/04

(54) **GREIFWERKZEUG, GREIFEINRICHTUNG UND GREIFVERFAHREN**
GRIPPING TOOL, GRIPPING DEVICE, AND GRIPPING METHOD
OUTIL, DISPOSITIF ET PROCÉDÉ DE PRÉHENSION

(30) Priorität: 27.06.2016 DE 202016103393 U
(43) Veröffentlichungstag der Anmeldung: 01.05.2019
(73) Patentinhaber: KUKA Systems GmbH, 86165 Augsburg (DE)
(72) Erfinder: HONSBERG, Otmar, 82256 Fürstenfeldbruck (DE); PROSKE, Jürgen, 86356 Neusäß (DE); CLAUDER, Tom, 86152 Augsburg (DE)
(74) Vertreter: Tillmann, Axel
(86) Internationale Anmeldenummer: PCT/EP2017/065680
(87) Internationale Veröffentlichungsnummer: WO 2018/001947

(56) Entgegenhaltungen:
- EP-A1- 2 258 643
- WO-A1-2012/038776
- DE-A1- 19 806 432
- DE-A1-102014 222 167
- FR-A1- 2 579 188
- US-A- 3 037 651
- US-A- 4 543 152
- US-A- 4 575 303
- US-A- 4 726 725
- US-A- 4 934 624

## Beschreibung

Die Erfindung betrifft ein Greifwerkzeug, eine Greifeinrichtung und ein Greifverfahren mit den Merkmalen im Oberbegriff des Verfahrens- und Vorrichtungshauptanspruchs.

Aus der Praxis ist es bekannt, Bestückungsautomaten für SMD-Bauteile mit SMD-Rollen zu beladen, bei denen die SMD-Bauteile auf einem aufgerollten Trägerband oder Trägergurt angeordnet sind. Die SMD-Rollen werden manuell gegriffen und be- und entladen.

Die US 4 543 152 A beschreibt eine Vorrichtung zum Spleißen von Bahnrollen.

Aus der EP 2 258 643 A1 ist ein Verfahren zum Beladen einer Zuführstation mit neuen Blechrollen bekannt.

In der US 4 934 624 A ist eine Roboterhand gezeigt.

Die US 4 726 725 A offenbart eine Ladungsgreifeinrichtung.

Es ist Aufgabe der vorliegenden Erfindung, eine verbesserte Greiftechnik aufzuzeigen.

Die Erfindung löst diese Aufgabe mit den Merkmalen im Verfahrens- und den Vorrichtungshauptansprüchen.

Die beanspruchte Greiftechnik, d.h. das Greifwerkzeug und die Greifeinrichtung nebst Greifverfahren, haben verschiedene Vorteile.

Das Greifwerkzeug lässt sich automatisch handhaben und bedienen. Es kann spulenartige und/oder scheibenartige Greifobjekte, bevorzugt SMD-Rollen oder dgl., führen und bevorzugt zentral greifen sowie abstützen und auch wieder loslassen. Derartige Greifobjekte haben z.B. einen Durchmesser, der größer als ihre Dicke ist. Außerdem ist es möglich, ein solches Greifobjekt zentral drehfähig zu halten bzw. zu lagern und im gegriffenen Zustand dessen Rotation zu ermöglichen. Alternativ ist ein drehfestes Greifen und Lagern möglich.

Das Greifwerkzeug hat für diese Funktionen eine geeignete konstruktive Ausbildung, die variieren kann. Mittels einer Detektionseinrichtung am Greifwerkzeug kann das korrekte Greifen und ggf. Abgeben eines Greifobjekts erfasst und überwacht werden. Das Greifwerkzeug kann mittels einer programmierbaren Handhabungseinrichtung, insbesondere eines Industrieroboters, bewegt und zum automatischen Transport sowie zum Aufnehmen und Abgeben der besagten Greifobjekte eingesetzt werden.

Das Greifwerkzeug weist ein Gestell mit einem Anschluss für eine programmierbare Handhabungseinrichtung, insbesondere einem Roboteranschluss, und einen Greifer mit einer steuerbaren Stelleinrichtung auf. Mit der Stelleinrichtung kann der Greifer mit seinen Greiffunktionen angetrieben und gesteuert werden. Der Greifer ist zum seitlichen Führen sowie zum zentralen Greifen und Stützen sowie gegebenenfalls drehfähigen Lagern eines Greifobjekts ausgebildet. Die Führung sowie das Greifen, Stützen und Lagern können einseitig oder mehrseitig, insbesondere beidseitig, erfolgen.

Die beanspruchte Greiftechnik ist insbesondere für schmale spulenartige oder rollenartige Greifobjekte von Vorteil. Diese können an eine Verarbeitungseinrichtung, z.B. einen Bestückungsautomaten, automatisch zugeführt und abgeführt werden. Sie können dort gehalten oder abgegeben werden. Ein spulenartiges oder rollenartiges Greifobjekt kann insbesondere drehend gehalten bzw. gelagert werden und kann in dieser Lage am Greifer bedarfsweise gedreht werden.Bei der Drehung kann ein am Greifobjekt, insbesondere einer Spule, angeordnetes Band aufgewickelt oder abgewickelt werden.

Dies ist insbesondere günstig, wenn die Enden von aufgespulten bzw. aufgewickelten Bändern, insbesondere Trägerbändern oder Trägergurten für SMD-Bauteile, manuell oder automatisch miteinander verbunden werden. Dies kann z.B. durch einen sogenannten Spleißvorgang erfolgen, wobei das Greifwerkzeug bzw. die Greifeinrichtung die neue Bandspule oder SMD-Rolle für diesen Verbindungs- oder Spleißvorgang in Position bringt und dabei drehfähig hält. Die Bandspule bzw. SMD-Rolle kann anschließend in eine vorgesehene Aufnahme an der Verarbeitungseinrichtung, z.B. ein Rack, übergeben und gegen die abgelaufene leere Bandspule bzw. SMD-Rolle getauscht werden.

Das aufgespulte bzw. aufgewickelte Band kann von einer am Greifwerkzeug angeordneten Zuführeinrichtung an die Verarbeitungseinrichtung zugeführt und übergeben werden. Diese Zuführung und ggf. auch der Spleißvorgang können automatisch, teilautomatisch oder manuell erfolgen. Der Verbindungsvorgang, insbesondere Spleißvorgang, kann auch durch eine formschlüssige Führung und einen gemeinsamen Transport des ablaufenden Bandendes und des neuen, zugeführten Bandendes ersetzt werden. Die Bandenden sind dabei im Stoß hintereinander geführt oder können auch einander überlappen.

Der Greifer weist erfindungsgemäß einen Tragarm mit einem endseitigen steuerbaren Greifmittel auf, das zum zentralen Greifen und Stützen sowie ggf. zum drehfähigen Lagern eines Greifobjekts an dessen zentraler Ausnehmung ausgebildet ist. Am anderen Ende kann der Tragarm mit dem Gestell des Greifwerkzeugs verbunden sein. Das Greifwerkzeug ist zur Aufnahme von einem oder mehreren Greifobjekten geeignet.

Der Tragarm kann einzeln oder mehrfach vorhanden sein. Mehrere parallele Tragarme können ein Greifobjekt beidseits führen. Der Tragarm kann eine längliche und abgeflachte, insbesondere plattenartige Form aufweisen und vom Gestell wegragen. Hierdurch ist eine kompakte und platzsparende Ausführung gegeben, die auch in eine Reihe von mehreren nebeneinander angeordneten Greifobjekten greifen und gezielt ein Greifobjekt fassen kann. Ein verstellbar am Gestell des Werkzeugs gelagerter Tragarm ermöglicht eine Anpassung an unterschiedliche Abmessungen, insbesondere Dicken, des Greifobjekts.

Der Greifer kann an einem oder mehreren Tragarmen jeweils ein steuerbares Greifmittel aufweisen, welches das besagte zentrale Greifen und Stützen eines oder mehrerer Greifobjekte ermöglicht. Das Greifmittel kann insbesondere als Greiffinger ausgebildet sein. Dies kann ein einzelner Greiffinger sein. Das Greifmittel kann mehrfach vorhanden sein. Mehrere gegenüberliegende Greifmittel können zusammenwirken und miteinander eine Abstützung und ggf. drehbare Lagerung für ein Greifobjekt bilden.

Das Greifmittel kann steuerbar sein, wobei es mit der Stelleinrichtung des Greifwerkzeugs verbunden sein kann. Insbesondere kann das Greifmittel angetrieben und gesteuert zwischen einer Freigabeposition und einer zentralen Eingriffsposition am Greifobjekt hin und her bewegt werden. Die Kinematik kann variieren. Sie kann z.B. eine Drehbewegung sein. Alternativ ist eine quer oder schräg zum Tragarm gerichtete translatorische Bewegung oder eine kombinierte rotatorische und translatorische Bewegung möglich.

Erfindungsgemäß weist das Greifmittel jeweils eine entlang des Tragarms verlaufende und bevorzugt um seine Längsachse drehbare Stellstange mit einem endseitigen, seitlichen Vorsprung auf, der bei Eingriff in eine zentrale Ausnehmung des Greifobjekts ein Stütz- und Drehlager bildet. Der Vorsprung kann als Stütz- und Lagernase ausgebildet sein. Der Vorsprung wird durch die Stellstangenbewegung, insbesondere durch deren Drehung, bewegt. In einer anderen Ausführung kann der seitliche Vorsprung über ein Keilgetriebe, eine fluidische oder magnetische Betätigung oder auf andere Weise, ggf. gegen ein federndes Rückstellelement, bewegt werden.

Die Greifeinrichtung für spulenartige und/oder scheibenartige Greifobjekte, insbesondere SMD-Rollen, kann eine ein- oder mehrachsig bewegliche, programmierbare Handhabungseinrichtung mit einem fest oder lösbaren montierten Greifwerkzeug der beschriebenen Art aufweist.

In einer Ausgestaltung ist die Handhabungseinrichtung als mehrachsiger programmierbarer Industrieroboter ausgebildet. Die Handhabungseinrichtung, insbesondere der Industrieroboter, kann eine zugeordnete Sensorik aufweisen, die äußere Belastungen aufnimmt. Die Sensorik kann an der Anbaustelle zwischen dem Abtriebselement der Handhabungseinrichtung und dem Greifwerkzeug angeordnet sein. Sie kann alternativ oder zusätzlich in die Handhabungseinrichtung, insbesondere einem mehrachsigen Industrieroboter, integriert sein.

Die Handhabungseinrichtung bzw. der Industrieroboter können über die Sensorik sensitive Fähigkeiten erhalten. Diese sind vorteilhaft, um das besagte Greifobjekt suchen und gezielt greifen zu können. Außerdem kann hierdurch eine exakte Positionierung des Greifobjekts, insbesondere bei dessen Abgabe, erreicht werden. Die Sensorik ermöglicht insbesondere ein tastendes Suchen des Greifobjekts, eine Kontrolle des exakten und positionsgerechten Greifens und Stützens des Greifobjekts sowie ggf. dessen drehbare Lagerung. Die exakte Position, insbesondere Abgabeposition, des Greifobjekts kann ebenfalls tastend gesucht und detektiert werden.

In den Unteransprüchen sind weitere vorteilhafte Ausgestaltungen der Erfindung angegeben.

Die Erfindung ist in den Zeichnungen beispielhaft und schematisch dargestellt. Im Einzelnen zeigen:
- Figur 1:: Eine Greifeinrichtung mit einem Industrieroboter und einem Greifwerkzeug sowie einem gegriffenen spulenartigen Greifobjekt in einer abgebrochenen perspektivischen Darstellung
- Figur 2:: Eine vergrößerte perspektivische Einzeldarstellung des Greifwerkzeugs und des Greifobjekts von Figur 1
- Figur 3:: Eine perspektivische Darstellung des geöffneten Greifwerkzeugs von Figur 1 und 2 ohne Greifobjekt
- Figur 4:: Eine abgebrochene Seitenansicht des Greifwerkzeugs mit Greifobjekt gemäß Figur 1 und 2
- Figur 5 und 6:: Querschnittsdarstellungen des Greifobjekts und des Greifwerkzeugs in Freigabeposition und in Greifposition gemäß Schnittlinien V-V und VI-VI von Figur 4,
- Figur 7:: Eine aufgebrochene Seitenansicht des Greifwerkzeugs mit Greifobjekt gemäß Figur 1 und 2
- Figur 8:: eine Verarbeitungseinrichtung mit einer Greifeinrichtung,
- Figur 9:: ein Greifwerkzeug mit einer Zuführeinrichtung für ein Band in einer perspektivischen Ansicht,
- Figur 10:: eine Seitenansicht des Greifwerkzeug gemäß Pfeil X von Figur 9 zusammen mit einem Roboterteil und
- Figur 11:: eine perspektivische Ansicht der Zuführeinrichtung von Figur 8 und 10 mit einem Band.

Die Erfindung betrifft ein Greifwerkzeug (2) für ein spulenartiges und/oder scheibenartiges Greifobjekt (4) sowie ein Greifverfahren. Die Erfindung betrifft ferner eine Greifeinrichtung (1) mit einer Handhabungseinrichtung (3) und einem von dieser geführten Greifwerkzeug (2) nebst Verfahren.

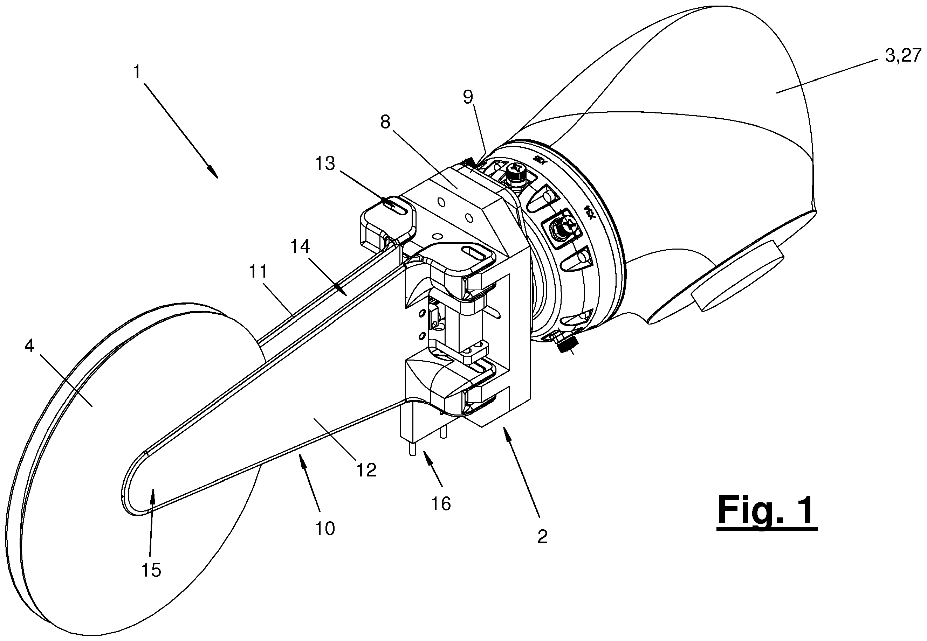

Das gezeigte Greifobjekt (4) ist spulenartig und rollenartig ausgebildet. Es hat z.B. gemäß Figur 1 und 4bis 6 eine kreisscheibenartige Form. Es kann einen kreisrunden Umfang und im Wesentlichen ebene Seitenflächen aufweisen. Sein Durchmesser ist größer als seine Dicke. Die Scheibenform kann alternativ anders aussehen.

Das Greifobjekt (4) besitzt einen zylindrischen Korpus (5) mit einer Aufnahmenut am Außenumfang für ein aufgewickeltes Band (6) oder einen Gurt. Dies kann z.B. ein Trägerband für SMD-Bauteile sein. Dies können z.B. elektronische Bauteile für die Bestückung einer Platine oder dgl. als Surface-Mounted Device (SMD) sein. Der Korpus (5) bildet einen Spulenkörper.

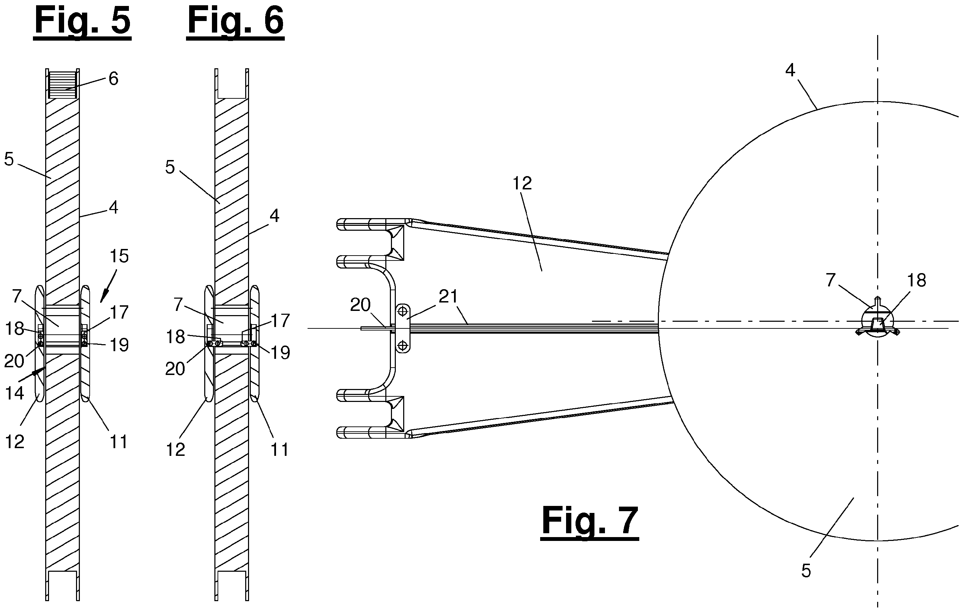

Der Durchmesser des scheibenartigen Korpus (5) ist vorzugsweise wesentlich größer als seine Dicke. In der Mitte weist das Greifobjekt (4) bzw. die Nabe des Spulenkörpers eine bevorzugt zentrale Ausnehmung (7) an einer oder beiden Seiten auf. Die Ausnehmung (7) kann als Nut bzw. Sackloch oder gemäß Figur 5 und 6 als Durchgangsöffnung durch den Korpus (5) ausgebildet sein. Sie kann eine beliebige Formgebung haben, z.B. zylindrisch mit randseitigen radialen Ausnehmungen. Sie kann dadurch eine Antriebsnabe mit radialen Mitnehmern aufnehmen.

Das Greifwerkzeug (2) kann automatisch gehandhabt und bedient werden. Es kann hierfür an einer programmierbaren Handhabungseinrichtung (3) montiert werden. Dies kann eine lösbare Verbindung sein, z.B. mittels einer Wechselkupplung. Letztere kann eine Medienkupplung für die Übertragung von Betriebsmitteln, z.B. Fluiden, elektrischen Signal- und/oder Leistungsströmen oder dgl. aufweisen. Die programmierbare Handhabungseinrichtung (3) ist vorzugsweise als mehrachsiger programmierbarer Industrieroboter ausgebildet. Das Greifwerkzeug (2) ist dabei an einem bevorzugt rotierenden Abtriebselement (28) der Handhabungseinrichtung (3) bzw. des Industrieroboters montiert.

Das Greifwerkzeug (2) weist ein Gestell (8) mit einem Anschluss (9) für die Handhabungseinrichtung (3) auf. Dieser ist vorzugsweise als Roboteranschluss ausgebildet. Er kann mechanische Verbindungsmittel und ggf. auch Verbindungsmittel für die besagten Betriebsmittel aufweisen. Das Gestell (8) weist ferner einen Greifer (10) mit einer steuerbaren Stelleinrichtung (16) auf.

Der Greifer (10) ist dazu ausgebildet, ein oder mehrere spulen- oder rollenartige Greifobjekte (4) seitlich zu führen, sowie zentral zu greifen und zu stützen. Der Greifer (10) kann außerdem bedarfsweise das Greifobjekt (4) zentral drehfähig lagern. Es kann im gegriffenen Zustand rotieren, wobei die Lagerung am Greifer (10) frei drehbar sein kann und die drehende Antriebskraft von außen kommt.

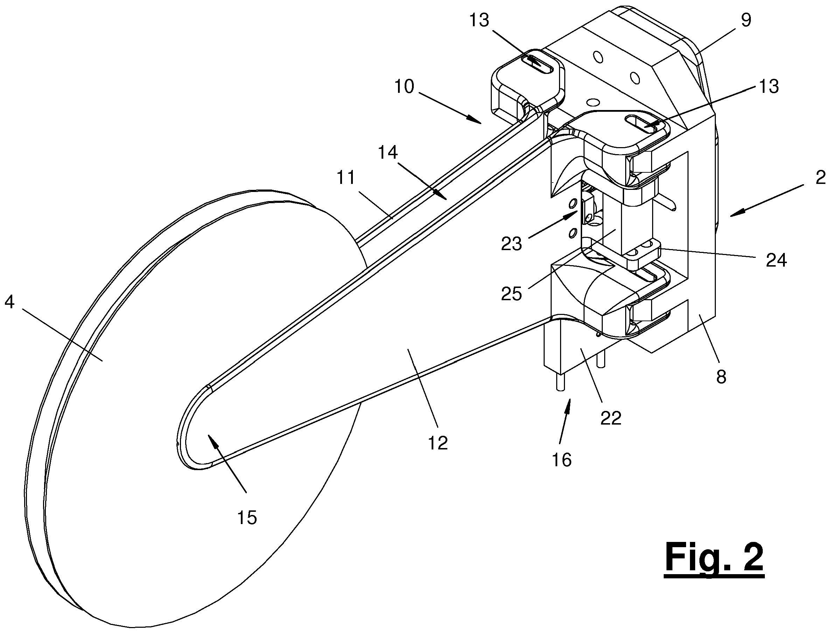

Der Greifer (10) kann für die vorgenannten Funktionen eine unterschiedliche konstruktive Ausbildung aufweisen. In Figur 1 bis 7 ist eine bevorzugte Ausführungsform gezeigt.

Der Greifer (10) weist einen Tragarm (11, 12) mit einem endseitigen steuerbaren Greifmittel (15) auf, das zum zentralen Greifen und Stützen sowie ggf. drehfähigen Lagern eines Greifobjekts (4) an dessen zentraler Ausnehmung (7) ausgebildet ist.

Alternativ können mehrere Greifobjekte (4) nebeneinander und/oder hintereinander sowie gemeinsam oder einzeln gegriffen, gestützt und eventuell drehfähig gelagert werden. Die nachfolgend beschrieben Ausführung für ein einzelnes Greifobjekt (4) kann entsprechend angepasst werden.

Der Greifer (10) kann einen einzelnen Tragarm (11, 12) mit einem endseitigen Greifmittel (15) aufweisen, der ein Greifobjekt (4) einseitig führt, greift und stützt sowie ggf. drehfähig lagert. Vorzugsweise weist der Greifer (10) mehrere, insbesondere zwei, Tragarme (11,12) auf, die parallel verlaufen und zwischen sich einen Freiraum (14) bilden, in dem ein Greifobjekt (4) aufgenommen werden kann. Die Parallelanordnung kann exakt parallel oder leicht konisch sein. Die Hauptebene von Tragarm(en) (11, 12) und Greifobjekt (4) sind in Greifstellung parallel ausgerichtet.

In weiterer Abwandlung können die insbesondere zwei Tragarme (11, 12) unterschiedlich lang ausgebildet sein, um die Greifobjekte (4) einfacher greifen bzw. "auffädeln" zu können. Beispielsweise können die Greifobjekte (4) mit dem voreilenden Tragarm (11 oder 12), in Kombination mit einem sensitivem Roboter oder sensitiv ausgestaltetem Greifwerkzeug (2), die Rollen ertasten und dann einfacher in den Zwischenspalt zwischen den beiden Tragarmen (11,12) eingebracht bzw. eingeführt oder "eingefädelt" werden.

Der oder die Tragarme (11, 12) weisen eine längliche und abgeflachte Form auf. Die bevorzugt plattenartig ausgebildeten Tragarme können in der Seitenansicht eine keilförmige Gestalt haben, die sich zum einen Ende hin verjüngt, an dem das Greifmittel (15) angeordnet ist. Der oder die Tragarme ragen vom Gestell (8) weg. Das breitere Armende weist zum Gestell (8). Der oder die Tragarme (11, 12) sind am Gestell (8) ortsfest oder mittels einer Lagerung (13) verstellbar gelagert. Das Gestell (8) kann z.B. flanschartig oder plattenartig ausgebildet sein, wobei an seiner Vorderseite der Greifer (10) mit dem oder den Tragarmen (11, 12) und an seiner Rückseite der Anschluss (9) angeordnet sind.

Die Tragarme (11, 12) sind so lang ausgebildet, dass die verschiedensten Greifobjekte (4), insbesondere Rollen oder Scheiben, aufgenommen werden können. Dies kann bevorzugt durchmesserunabhängig erfolgen.

Die Lagerung (13) kann unterschiedlich ausgebildet sein. Es kann sich z.B. um eine Schiebelagerung handeln, die eine Verstellung quer zur Längserstreckung der Tragarme (11, 12) ermöglicht. Hierüber kann der Armabstand bzw. die Weite des Freiraums (14) eingestellt werden. Alternativ oder zusätzlich kann die Lagerung (13) z.B. als Schwenklagerung ausgebildet sein, die ein Auf- und Zuklappen bzw. Öffnen und Schließen der Tragarme (11, 12) ermöglicht und die ggf. mit der Stelleinrichtung (16) verbunden ist. Zur Bildung der Lagerung (13) können der oder die Tragarme (11,12) z.B. am rückwärtigen Ende (2) distanziert Lageransätze mit Langlöchern aufweisen, die frontal abstehende Lagerflansche am Gestell (8) übergreifen und hier durch Bolzen und ggf. Klemmmittel fest oder lösbar bzw. verstellbar verbunden sind.

Des Weiteren kann die Lagerung (13) auch mit einer Aktorik (z.B. Hubzylinder, Motor-Spindel-Kombination) versehen sein, um einen oder beide Tragarme (11, 12) automatisch verstellen zu können. Hierdurch kann zusätzlich eine Parallelgreiffunktion erreicht werden.

Der oder die Tragarme (11,12) weisen jeweils ein steuerbares Greifmittel (15) auf, welches mit der Stelleinrichtung (16) verbunden sein kann. Das Greifobjekt (4) wird von dem oder den Tragarmen (11, 12) an einer oder beiden Stirnseiten seitlich umgriffen und geführt. Das gesteuert bewegliche Greifmittel (15) bewirkt das zentrale Greifen und Stützen sowie ggf. drehfähige Lagern des Greifobjekts (4) am Greifer (10).

Das Greifmittel (15) kann in unterschiedlicher Weise ausgebildet sein und kann eine unterschiedliche Kinematik haben. Im gezeigten Ausführungsbeispiel ist es als Greiffinger ausgebildet. Beide Tragarme (11, 12) können dabei jeweils ein Greifmittel (15) bzw. einen Greiffinger aufweisen. Die mehrfachen Greifmittel (15) bewirken miteinander das zentrale Greifen, Stützen und gegebenenfalls drehfähige Lagern des Greifobjekts (4). Alternativ kann nur ein Tragarm (11,12) ein Greifmittel (15) aufweisen.

Die Stelleinrichtung (16) beaufschlagt ein einzelnes oder mehrere Greifmittel (15). Sie bewirkt dabei deren Antrieb und steuert deren Bewegungen.

Das Greifmittel (15) kann unterschiedlich ausgebildet und angeordnet sein. In den gezeigten Ausführungsbeispielen weist es jeweils eine entlang des Tragarms (11, 12) verlaufende Stellstange (19,20) mit einem endseitigen, seitlichen Vorsprung (17,18) auf. Der Vorsprung (17,18) ist als Stütz- und Lagernase ausgebildet. Er ist bevorzugt keilförmig ausgebildet und ist an die Größe der zentralen Ausnehmung (7) des Greifobjekts (4) angepasst. Der'Vorsprung (17, 18) greift von außen her in die Ausnehmung (7) mechanisch ein. Dies kann z.B. durch eine Drehbewegung erfolgen. Der z.B. flanschartige oder plattenartige Vorsprung (17,18) hat hierfür geeignete Abmessungen.

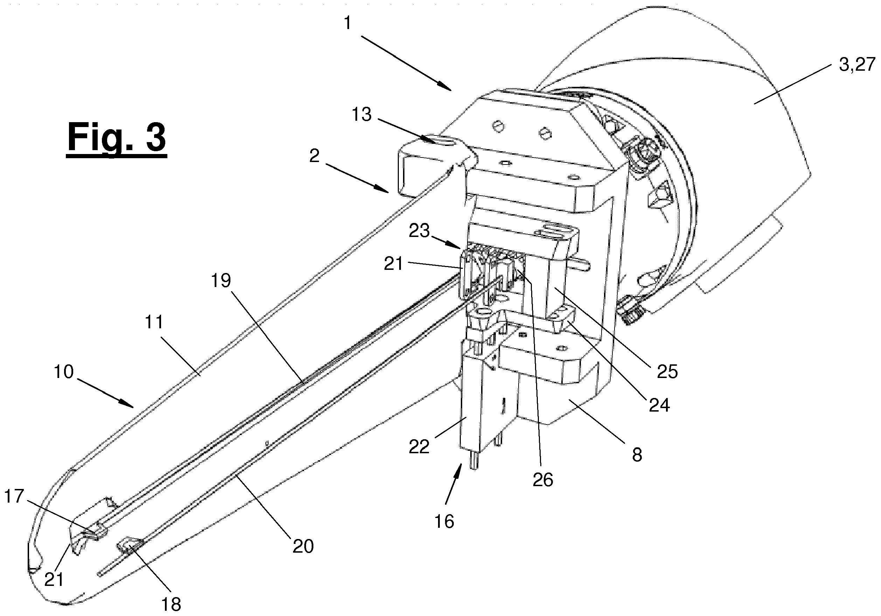

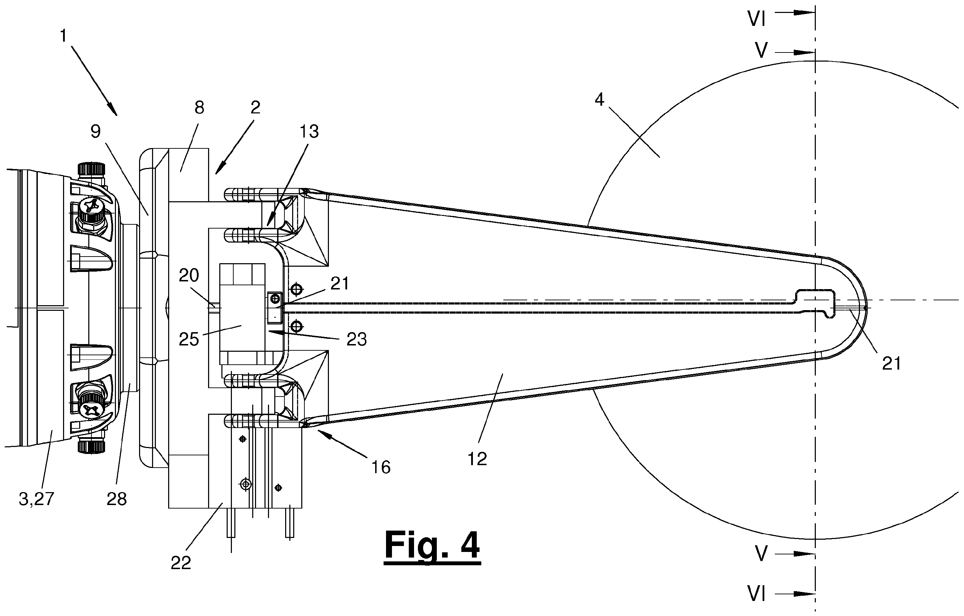

Die Stellstange (19,20) ist drehbar am Greifer (10), insbesondere am jeweiligen Tragarm (11,12), gelagert. Hierfür ist eine Stangenlagerung (21) vorgesehen, die z.B. eine hintere Lagerschale am rückwärtigen und verbreiterten Ende des Tragarms (11,12) und eine axiale Einstecköffnung für einen frontseitigen Stangenfortsatz am vorderen Armende aufweist. Figur 3, 4 und 7 zeigen diese Ausbildung. Die Stellstange (19,20) wird durch das Stangenlager (21) z.B. um ihre Längsachse drehbar und in Axialrichtung fest oder begrenzt verschieblich gehalten. Der oder die Tragarme (11, 12) können am vorderen Ende innenseitig eine Aussparung zur Aufnahme des Vorsprungs (17, 18) aufweisen. Figur 3 und 4 zeigen diese Ausbildung.

Die Stellstange(n) (19,20) ist/sind am anderen und vom Vorsprung (17,18) abgewandten Ende mit der Stelleinrichtung (16) verbunden. Die Stelleinrichtung (16) treibt die Stellstange(n) (19,20) an und dreht den jeweiligen Vorsprung (17, 18) in die Greif- und Stützposition einerseits und die Freigabeposition andererseits.

Die Stelleinrichtung (16) ist am Gestell (8) des Greifwerkzeugs (2) angeordnet. Sie weist einen steuerbaren Stellantrieb (22) mit einem Getriebe (23) zur Betätigung von ein oder mehreren Greifmitteln (15), insbesondere von einer oder mehreren Stellstangen (19,20), auf. Der steuerbare Stellantrieb (22) weist z.B. einen fluidischen Zylinder, einen elektrischen Spindel- oder Zahnstangenantrieb oder ein anderes Antriebsmittel auf. Das Getriebe (23) ist z.B. gemäß Figur 3 als Zahnstangengetriebe ausgebildet und setzt die lineare Antriebsbewegung des Stellantriebs (22) in eine Drehbewegung der Stellstange(n) (19,20) um. An der oder den Stellstangen (19,20) ist dabei endseitig jeweils ein Zahnrad (26) angeordnet, welches mit einer Zahnstange (25) kämmt, die an einem mit dem Stellantrieb (22) verbundenen Joch (24) angeordnet ist. Der Stellantrieb (22) kann in der gezeigten Ausführung beide Stellstangen (19, 20) synchron mit gegenläufiger Drehung gesteuert antreiben. Die Stelleinrichtung (16) bzw. der Stellantrieb (22) kann z.B. einen Schritt- oder Servomotor aufweisen, wodurch genaue Winkeleinstellungen realisierbar sind.

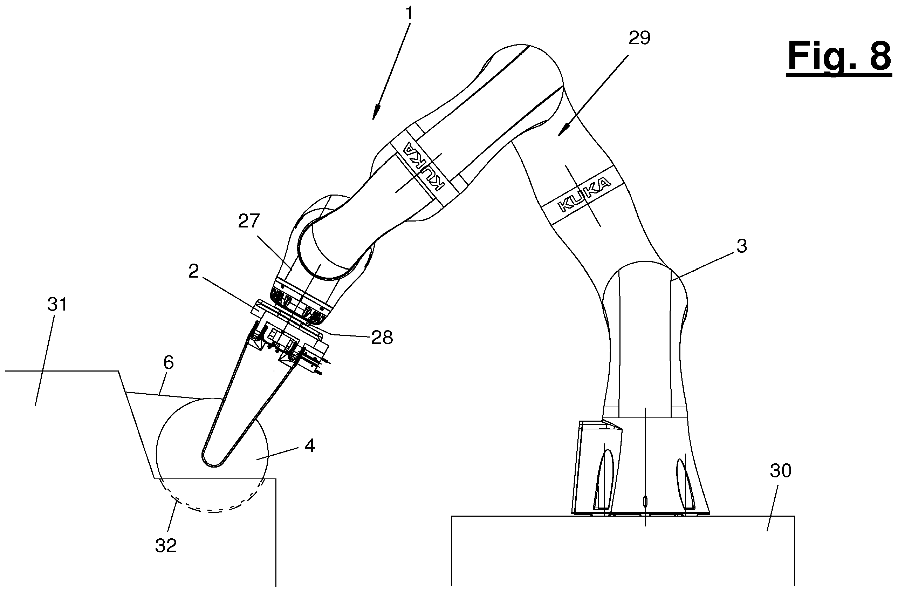

Die ein- oder mehrachsig beweglich und programmierbare Handhabungseinrichtung (3) ist z.B. in der vorerwähnten Weise als mehrachsiger programmierbarer Industrieroboter gemäß Figur 8 ausgebildet. Dieser kann mehrere translatorische und/oder rotatorische Roboterachsen sowie mehrere Roboterglieder aufweisen. In Figur 1 und 3 ist ein Endglied (27) der Handhabungseinrichtung (3) bzw. des Industrieroboters mit einem bevorzugt drehenden Abtriebselement (28) in Montageverbindung mit dem Anschluss (9) dargestellt.

Die Handhabungseinrichtung (3) bzw. der Industrieroboter führt das Greifwerkzeug (2) und transportiert damit die aufgenommenen Greifobjekte (4). Die Handhabungseinrichtung (3) kann dabei stationär oder auf einem manuell oder automatisch bewegten Transportmittel (30) angeordnet sein. Sie stellt die Greifobjekte (4) an einer in Figur 8 gezeigten Verarbeitungseinrichtung (31) zu. Letztere kann z.B. ein Bestückungsautomat für SMD-Bauteile sein. Das Greifobjekt (4) kann in einem z.B. wannenartigen Spulenhalter (32) eingelegt bzw. positioniert werden. Das abgespulte Band (6) kann in die Verarbeitungseinrichtung (31) eingeführt werden.

Die Handhabungseinrichtung (3) weist eine zugeordnete Sensorik (29) auf, die äußere Belastungen aufnimmt und auswertet sowie einer Steuerung, insbesondere einer Robotersteuerung, übermittelt. Die Sensorik kann einteilig oder mehrteilig sein und kann ein oder mehrere belastungsaufnehmende Sensoren, z.B. Kraft- und/oder Momentensensoren, aufweisen. Sie kann ferner ein oder mehrere andere Sensoren, z.B. für die Wegmessung, Winkelmessung oder dgl. aufweisen.

Die Sensorik (29) kann in unterschiedlicher Weise der Handhabungseinrichtung (3) zugeordnet sein. Sie kann z.B. zwischen dem Anschluss (9) und dem Abtriebselement (28) der Handhabungseinrichtung (3) angeordnet sein. Sie kann auch in das Greifwerkzeug (2) integriert sein. In der gezeigten und bevorzugten Ausführungsform ist die Sensorik (29) in den Industrieroboter (3) integriert. Hierbei können an ein oder mehreren Roboterachsen, insbesondere an deren Lagerungen, jeweils ein belastungsaufnehmender Sensor und ggf. ein weiterer Sensor in geeigneter Zahl und Anordnung vorhanden sein.

Die Handhabungseinrichtung (3) ist vorzugsweise als taktiler Industrieroboter mit sensitiven Fähigkeiten und mit der besagten integrierten Sensorik (29) ausgebildet. Die sensitiven Fähigkeiten können zum Suchen und Greifen eines Greifobjekts (4) und bei dessen Zustellung bzw. Positionierung an einer Verarbeitungseinrichtung (31) genutzt werden. Sie sind auch für andere Prozesse, z.B. beim Spleißen des Bands (6), von Vorteil.

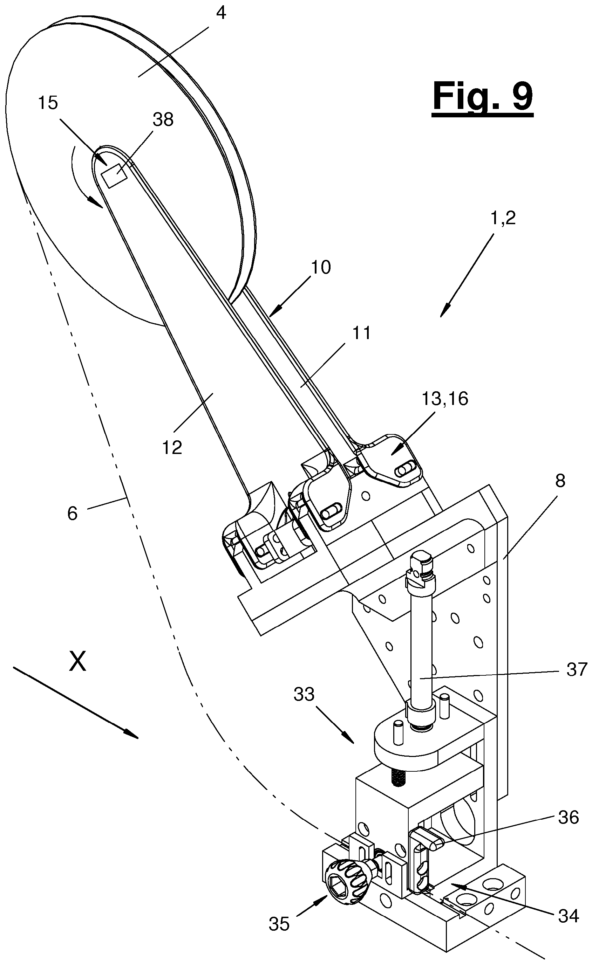

Das Greifwerkzeug (2) weist in der Ausführungsform von Figur 9 bis 11 eine Zuführeinrichtung (33) für das Band (6) auf. Die Zuführeinrichtung (33) ist am Gestell (8) angeordnet. Sie befindet sich vorzugsweise an der Rückseite des Greifers (10) und ist mit Abstand vom Greifobjekt (4) bzw. dem Greifmittel (15) angeordnet. Das Gestell (8) hat eine abgewinkelte Form, wobei der Roboteranschluss (9) im Vergleich mit dem ersten Ausführungsbeispiel in einer z.B. um 90° gedrehten Position angeordnet ist. Das Greifwerkzeug (2) kann ansonsten wie im ersten Ausführungsbeispiel von Figur 1 bis 8 ausgebildet sein.

Die Zuführeinrichtung (33) dient der Zuführung des Bandes (6) vom Greifobjekt (4) zur Verarbeitungseinrichtung (31). Hierdurch kann das Band (6) an einer Übergabestelle exakt geführt, fixiert und positioniert werden. Die Zuführeinrichtung (33) kann auch für eine Betätigung von Teilen der Verarbeitungseinrichtung (31) benutzt werden, z.B. von einem Verschluss einer dortigen Führungs- und Antriebsvorrichtung für das Band (6). Die Zuführeinrichtung (33) kann dabei von der bevorzugt taktilen Handhabungseinrichtung (3) geführt und in ihren Funktionen gesteuert werden.

Die Zuführeinrichtung (33) kann eine oder mehrere Komponenten aufweisen.

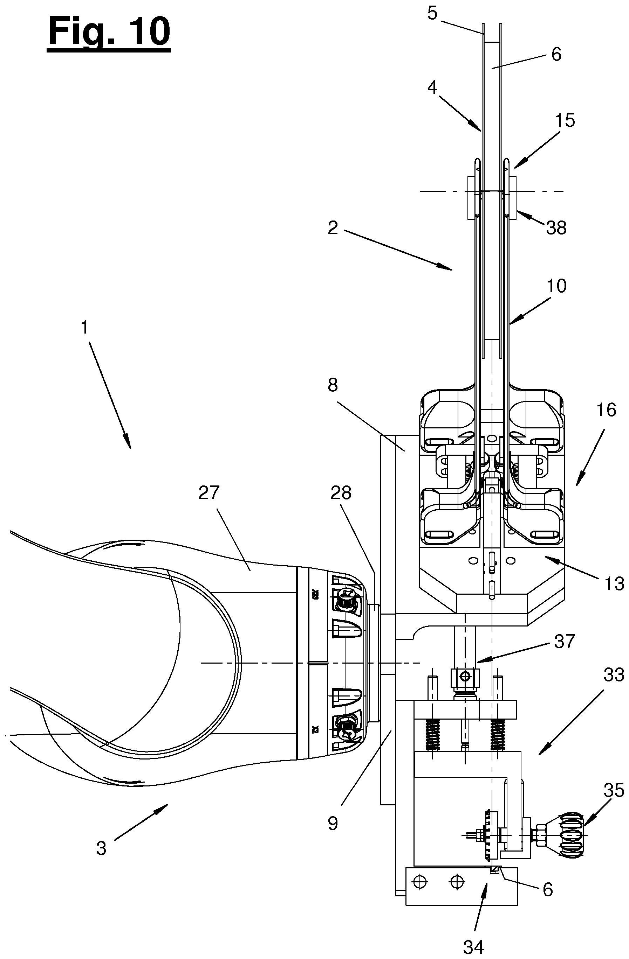

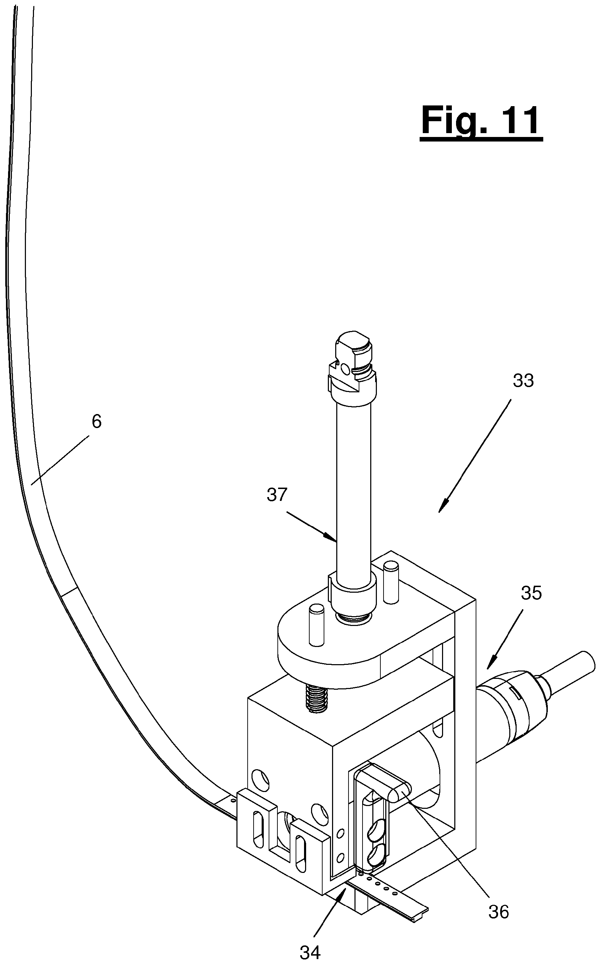

Eine solche Komponente kann eine Führung (34) für das Band (6) sein. Diese kann z.B. ein Führungsbett an einem Korpus der Zuführeinrichtung (33) aufweisen. Zur Führung (34) kann auch ein formschlüssiges und bewegliches Führungsmittel für das Band (6) vorgesehen sein, z.B. eine Stachelwalze gemäß Figur 10. Das Band kann gemäß Figur 11 eine Lochung oder ein anderes Gegenelement für die formschlüssige Führung aufweisen. Die Führung (34) kann auch ein abstehendes Leitmittel, z.B. eine Leitzunge, aufweisen. Dieses kann zur Positionierung der Zuführeinrichtung (33) gegenüber einem Bandeinlauf der Verarbeitungseinrichtung (31) und zum sicheren Führen des Bandes (6) bei der Übergabe dienen.

Eine weitere Komponente der Zuführeinrichtung kann eine Fixiereinrichtung (37) sein, mit der das eingelegte Band (6) an der Führung (34) fixiert oder gelöst werden kann. Die Fixiereinrichtung (37) kann steuerbar sein. Sie kann ein z.B. schlittenartiges Klemmmittel mit einem Zylinder oder einem anderen Antriebsmittel aufweisen. An der Fixiereinrichtung (37), insbesondere am Klemmmittel, kann auch das vorgenannte bewegliche Führungsmittel, insbesondere die Stachelwalze, angeordnet sein.

Eine andere Komponente der Zuführeinrichtung (33) kann eine Treibeinrichtung (35) sein, mit der das Band (6) an der Zuführeinrichtung (33) angetrieben und bewegt werden kann. Die Treibeinrichtung (35) kann mit dem beweglichen Führungsmittel, insbesondere der Stachelwalze, verbunden sein. Sie kann für eine manuelle Betätigung einen Drehknopf oder dgl. gemäß Figur 9 oder einen steuerbaren Antrieb gemäß Figur 11 aufweisen. Ferner kann ein Freilauf vorhanden sein, der einen Antrieb des übergebenen und in der Fixiereinrichtung (37) geklemmten Bandes (6) durch die Verarbeitungseinrichtung (31) erlaubt.

Die Zuführeinrichtung (33) kann auch eine Komponente in Form eines Betätigers (36) aufweisen. Mit diesem können externe Vorrichtungen betätigt werden. Z.B. kann ein Bandeinlauf an einem Bandförderer der Verarbeitungseinrichtung (31) geöffnet und geschlossen werden. Das Greifwerkzeug (2) und der z.B. starre Betätiger (36) können hierfür von der vorbeschriebenen Handhabungseinrichtung (3) entsprechend bewegt werden, vorzugsweise unter Nutzung ihrer sensitiven Fähigkeiten. Die sensitiven Fähigkeiten können auch für eine Funktionskontrolle benutzt werden, z.B. für die Öffnungs- und Schließstellung des Bandeinlaufs und/oder für die formschlüssige Aufnahme und den Transport des neuen Bandendes am Bandeinlauf.

Die zweite Variante des Greifwerkzeugs von Figur 9 bis 11 zeigt außerdem eine Ergänzung des Greifwerkzeugs (2) mit einer Stabilisierungseinrichtung (38) für den Greifer (10). Diese kann für den sicheren Halt des aufgenommenen Greifobjekts (4) am Greifer (10) sorgen. Sie ist insbesondere für die flachen Tragarme (11,12) von Vorteil. Sie gleicht deren Biegeelastizität um die Querachse aus und hält die Tragarme (11, 12) in Greifstellung am Greifobjekt (4). Die Stabilisierungseinrichtung (38) kann z.B. die gezeigte Magnetanordnung aufweisen, bei der die beidseitigen Magnete die Tragarme (11, 12) in Greifstellung gegeneinander ziehen.Abwandlungen der gezeigten und beschriebenen Ausführungsform sind in verschiedener Weise möglich. Insbesondere können die Merkmale der vorbeschriebenen Ausführungsbeispiele und der genannten Abwandlungen beliebig miteinander kombiniert, insbesondere auch vertauscht werden.

Das Greifobjekt (4) kann in anderer Weise ausgebildet sein, z.B. als massiver Körper. Statt der gezeigten Scheibenform mit rotationssymmetrischem Umfang und ebenen Seitenflächen kann eine beliebige andere Seitenkontur und/oder Umfangskontur vorhanden sein. Ein scheibenartiges Greifobjekt (4) kann z.B. einen ovalen oder prismatischen Umfang aufweisen. Es kann auch eine oder mehrere nicht-ebene Seitenfläche(n) aufweisen. Die Ausnehmung (7) kann an anderer Stelle und ggf. außermittig angeordnet sein. Variabel sind auch die mit einem Greifobjekt (4) ausgeführten Prozesse und die ggf. vorhandene Verarbeitungseinrichtung (31).

Der Greifer (10) kann ein anderes und gegebenenfalls einzelnes Greifmittel (15) aufweisen. Es kann z.B. einen Greiffinger aufweisen, der quer zur Armebene bzw. Korpusebene translatorisch aus- und eingefahren wird. Ein fingerartiges Greifmittel (15) kann auch durch Verformung eines Körpers gebildet und betätigt werden. Die Stelleinrichtung (16) kann entsprechend konstruktiv und funktional abgewandelt werden. Sie kann z.B. einen fluidischen Antrieb aufweisen, der ein kolbenartiges Greifmittel (15) gesteuert bewegt. Die Stelleinrichtung (16) kann das Greifmittel (15) in die Greifstellung zustellen und in die Freigabestellung rückstellen. Die Rückstellung kann alternativ durch ein anderes Rückstellelement erfolgen, welches z.B. kompressibel oder federnd ausgebildet ist. Ein Getriebe (23) der Stelleinrichtung (16) kann entfallen oder in anderer Weise für eine Kraft- und Bewegungsübertragung ausgebildet sein.

### BEZUGSZEICHENLISTE

1. Greifeinrichtung
2. Greifwerkzeug
3. Handhabungseinrichtung, Industrieroboter
4. Greifobjekt, Bandspule, SMD-Rolle
5. Korpus, Spulenkörper
6. Band, Trägerband
7. Ausnehmung
8. Gestell
9. Anschluss, Roboteranschluss
10. Greifer
11. Tragarm
12. Tragarm
13. Lagerung verstellbar
14. Freiraum
15. Greifmittel, Greiffinger
16. Stelleinrichtung
17. Vorsprung, Stütz- und Lagernase
18. Vorsprung, Stütz- und Lagernase
19. Stellstange
20. Stellstange
21. Stangenlagerung
22. Stellantrieb, Zylinder
23. Getriebe
24. Joch
25. Zahnstange
26. Zahnrad
27. Endglied
28. Abtriebselement
29. Sensorik
30. Transportmittel
31. Verarbeitungseinrichtung, Bestückungseinrichtung
32. Halter, Spulenhalter
33. Zuführeinrichtung
34. Führung
35. Treibeinrichtung
36. Betätiger
37. Fixiereinrichtung
38. Stabilisierungseinrichtung

## Patentansprüche

1. Greifwerkzeug für spulenartige und/oder scheibenartige Greifobjekte (4), insbesondere SMD-Rollen, wobei das automatisch handhabbare und bedienbare Greifwerkzeug (2) ein Gestell (8) mit einem Anschluss (9), insbesondere einem Roboteranschluss, und einen Greifer (10) mit einer steuerbaren Stelleinrichtung (16) aufweist, der zum seitlichen Führen sowie zum zentralen Greifen und Stützen eines Greifobjekts (4) ausgebildet ist, **dadurch gekennzeichnet, dass** der Greifer (10) einen Tragarm (11, 12) mit einem endseitigen steuerbaren Greifmittel (15) aufweist, das zum zentralen Greifen und Stützen sowie ggf. drehfähigen Lagern eines Greifobjekts (4) an dessen zentraler Ausnehmung (7) ausgebildet ist, wobei das steuerbare Greifmittel (15) eine entlang des Tragarms (11, 12) verlaufende Stellstange (19,20) mit einem endseitigen, seitlichen Vorsprung (17,18) aufweist.

2. Greifwerkzeug nach Anspruch 1, **dadurch gekennzeichnet, dass** der Greifer (10) zum zentralen drehfähigen Lagern eines Greifobjekts (4) ausgebildet ist.

3. Greifwerkzeug nach Anspruch 1, **dadurch gekennzeichnet, dass** der Tragarm (11, 12) eine längliche und abgeflachte Form aufweist und vom Gestell (8) wegragt und der Tragarm (11, 12) am Gestell (8) ortsfest oder verstellbar gelagert (13) ist.

4. Greifwerkzeug nach einem der vorhergehenden Ansprüche, **dadurch gekennzeichnet, dass** der Greifer (10) mehrere, insbesondere zwei, parallele Tragarme (11, 12) aufweist, die zwischen sich ein Greifobjekt (4) aufnehmen.

5. Greifwerkzeug nach Anspruch 4, **dadurch gekennzeichnet, dass** mehrere, insbesondere beide, Tragarme (11, 12) jeweils ein steuerbares Greifmittel (15) aufweisen.

6. Greifwerkzeug nach einem der Ansprüche 1, 3 oder 5, **dadurch gekennzeichnet, dass** das Greifmittel (15) mit der Stelleinrichtung (16) verbunden ist und/oder die Stelleinrichtung (16) am Gestell (8) angeordnet ist.

7. Greifwerkzeug nach einem der Ansprüche 1, 3, 5 oder 6, **dadurch gekennzeichnet, dass** die Stelleinrichtung (16) ein einzelnes oder mehrere Greifmittel (15) beaufschlagt, wobei sie deren Antrieb bewirkt und deren Bewegungen steuert.

8. Greifwerkzeug nach Anspruch 1, **dadurch gekennzeichnet, dass** der Vorsprung (17,18) als Stütz- und Lagernase ausgebildet ist und/oder der Vorsprung (17,18) keilförmig ausgebildet und an die Größe der zentralen Ausnehmung (7) des Greifobjekts (4) angepasst ist.

9. Greifwerkzeug nach Anspruch 8, **dadurch gekennzeichnet, dass** die Stellstange (19,20) um ihre Längsachse drehbar am Greifer (10) gelagert und mit der Stelleinrichtung (16) verbunden ist.

10. Greifwerkzeug nach einem der Ansprüche 1,3, 5, 6 oder 7, **dadurch gekennzeichnet, dass** das Greifmittel (15) einen endseitigen, seitlichen Vorsprung (17, 18) aufweist, der über ein Keilgetriebe, eine fluidische oder magnetische Betätigung oder auf andere Weise, ggf. gegen ein federndes Rückstellelement, bewegt wird.

11. Greifwerkzeug nach einem der vorhergehenden Ansprüche, **dadurch gekennzeichnet, dass** die Stelleinrichtung (16) einen steuerbaren Stellantrieb (22) mit einem Getriebe (23), bevorzugt ausgebildet als Zahnstangengetriebe zur Umsetzung einer linearen Antriebsbewegung in eine Drehbewegung der Stellstange(n) (19,20) zur Betätigung von einer oder mehreren Stellstangen (19,20) aufweist.

12. Greifwerkzeug nach einem der vorhergehenden Ansprüche, **dadurch gekennzeichnet, dass** das Greifwerkzeug eine Zuführeinrichtung (33) für ein am Greifobjekt (4) angeordnetes Band (6) aufweist.

13. Greifeinrichtung für spulenartige und/oder scheibenartige Greifobjekte (4), insbesondere SMD-Rollen, wobei die Greifeinrichtung (1) eine ein- oder mehrachsig bewegliche, programmierbare Handhabungseinrichtung (3) mit einem nach Anspruch 1 angebauten Greifwerkzeug (2) aufweist.

14. Greifeinrichtung nach Anspruch 13, **dadurch gekennzeichnet, dass** die Handhabungseinrichtung (3) eine zugeordnete Sensorik (29) aufweist, die äußere Belastungen aufnimmt.

15. Verfahren zum Greifen und Handhaben von einem spulenartigen und/oder scheibenartigen Greifobjekt (4), insbesondere einer SMD-Rolle, mittels eines Greifwerkzeugs (2), wobei das Greifwerkzeug (2) von einer ein- oder mehrachsig beweglichen, programmierbaren Handhabungseinrichtung (3) automatisch gehandhabt und bedient wird, wobei das Greifobjekt (4) vom Greifwerkzeug (2) mit einem Greifer (10) mit einer steuerbaren Stelleinrichtung (16) zentral gegriffen und geführt wird, **dadurch gekennzeichnet, dass** der Greifer (10) einen Tragarm (11, 12) mit einem endseitigen steuerbaren Greifmittel (15) aufweist, wobei das steuerbare Greifmittel (15) eine entlang des Tragarms (11, 12) verlaufende Stellstange (19,20) mit einem endseitigen, seitlichen Vorsprung (17, 18) aufweist und das Greifobjekt (4) weiterhin an dessen zentraler Ausnehmung (7) vom endseitig steuerbaren Greifmittel (15) zentral gegriffen und gestützt sowie ggf. drehfähig gelagert wird.

## Claims

1. Gripping tool for coil-like and/or disc-like gripping objects (4), in particular SMD reels, wherein the automatically handleable and operable gripping tool (2) comprises a frame (8) with a connection (9), in particular a robot connection, and a gripper (10) with a controllable adjusting device (16), which is designed for lateral guidance as well as for central gripping and support of a gripping object (4), **characterized in that** the gripper (10) has a support arm (11, 12) with an end-side controllable gripping means (15) which is designed for central gripping and support, and optionally for rotatable mounting, of a gripping object (4) at its central recess (7), wherein the controllable gripping means (15) having an adjusting rod (19, 20) which extends along the support arm (11, 12) with a lateral projection (17, 18) at the end.

2. Gripping tool according to claim 1, **characterized in that** the gripper (10) is designed for the central rotatable mounting of a gripping object (4).

3. Gripping tool according to claim 1, **characterized in that** the support arm (11, 12) has an elongated and flattened shape and projects away from the frame (8) and the support arm (11, 12) is mounted (13) in a stationary or adjustable manner on the frame (8).

4. Gripping tool according to one of the preceding claims, **characterised in that** the gripper (10) has several, in particular two, parallel support arms (11, 12) which receive a gripping object (4) between them.

5. Gripping tool according to claim 4, **characterised in that** several, in particular both, support arms (11, 12) each have a controllable gripping means (15).

6. Gripping tool according to one of claims 1, 3 or 5, **characterised in that** the gripping means (15) is connected to the adjusting device (16) and/or the adjusting device (16) is arranged on the frame (8).

7. Gripping tool according to one of the claims 1, 3, 5 or 6, **characterised in that** the adjusting device (16) acts on a single or several gripping means (15), wherein it effects the drive thereof and controls the movements thereof.

8. Gripping tool according to claim 1, **characterized in that** the projection (17, 18) is designed as a support and bearing nose and/or the projection (17, 18) is wedge-shaped and is adapted to the size of the central recess (7) of the gripping object (4).

9. Gripping tool according to claim 8, **characterised in that** the adjusting rod (19, 20) is mounted on the gripper (10) so as to be rotatable about its longitudinal axis and is connected to the adjusting device (16).

10. Gripping tool according to any one of the claims 1, 3, 5, 6 or 7, **characterized in that** the gripping means (15) has a lateral projection (17, 18) at the end, which is moved by means of a wedge gear, a fluidic or magnetic actuation or in another way, possibly against a resilient return element.

11. Gripping tool according to one of the preceding claims, **characterized in that** the adjusting device (16) has a controllable actuator (22) with a gear (23), preferably designed as a rack and pinion gear for converting a linear drive movement into a rotary movement of the adjusting rod(s) (19, 20) for actuating one or more adjusting rods (19, 20).

12. Gripping tool according to one of the preceding claims, **characterized in that** the gripping tool has a feed device (33) for a belt (6) arranged on the gripping object (4).

13. Gripping device for reel-like and/or disc-like gripping objects (4), in particular SMD reels, wherein the gripping device (1) comprises a programmable handling device (3) movable in one or more axes and having a gripping tool (2), according to claim 1, attached.

14. Gripping device according to claim 13, **characterized in that** the handling device (3) has an associated sensor system (29) which absorbs external loads.

15. Method for gripping and handling a coil-like and/or disc-like gripping object (4), in particular an SMD roll, by means of a gripping tool (2), the gripping tool (2) being automatically handled and operated by a programmable handling device (3) which can be moved in one or more axes, the gripping object (4) being centrally gripped and guided by the gripping tool (2) with a gripper (10) having a controllable adjusting device (16), **characterized in that** the gripper (10) has a support arm (11, 12) with an endside controllable gripping means (15), wherein the controllable gripping means (15) has an adjusting rod (19, 20) extending along the support arm (11, 12) with a lateral projection (17, 18) at the end and the gripping object (4) is further gripped and supported, and optionally rotatably mounted, centrally at its central recess (7) by the controllable gripping means (15).

## Revendications

1. Outil de préhension pour des objets de préhension (4) en forme de bobine et/ou de disque, en particulier des bobines CMS, dans lequel l'outil de préhension (2) pouvant être manipulé et actionné automatiquement comprend un cadre (8) avec un raccord (9), en particulier un raccord de robot, et une préhenseur (10) avec un dispositif de réglage (16) pouvant être commandé, qui est conçu pour le guidage latéral ainsi que pour la préhension et le support central d'un objet de préhension (4), **caractérisé en ce que** la préhenseur (10) présente un bras de support (11, 12) avec un moyen de préhension (15) pouvant être commandé à l'extrémité, qui est conçu pour la préhension et le support centraux, et éventuellement pour le montage rotatif, d'un objet de préhension (4) au niveau de son évidement central (7), le moyen de préhension (15) pouvant être commandé présentant une tige de réglage (19, 20) qui s'étend le long du bras de support (11, 12) avec une saillie latérale (17, 18) à l'extrémité.

2. Outil de préhension selon la revendication 1, **caractérisé en ce que** la préhenseur (10) est conçu pour le montage central rotatif d'un objet de préhension (4).

3. Outil de préhension selon la revendication 1, **caractérisé en ce que** le bras de support (11, 12) a une forme allongée et aplatie et fait saillie à partir du cadre (8) et le bras de support (11, 12) est monté (13) de manière fixe ou réglable sur le cadre (8).

4. Outil de préhension selon l'une des revendications précédentes, **caractérisé en ce que** la préhenseur (10) présente plusieurs, en particulier deux, bras de support parallèles (11, 12) qui reçoivent entre eux un objet de préhension (4).

5. Outil de préhension selon la revendication 4, **caractérisé en ce que** plusieurs, en particulier les deux, bras de support (11, 12) ont chacun un moyen de préhension (15) pouvant être commandé.

6. Outil de préhension selon l'une des revendications 1, 3 ou 5, **caractérisé en ce que** le moyen de préhension (15) est relié au dispositif de réglage (16) et/ou le dispositif de réglage (16) est disposé sur le cadre (8).

7. Outil de préhension selon l'une des revendications 1, 3, 5 ou 6, **caractérisé en ce que** le dispositif de réglage (16) agit sur un ou plusieurs moyens de préhension (15), dans lequel il effectue l'entraînement de ceux-ci et en commande les mouvements.

8. Outil de préhension selon la revendication 1, **caractérisé en ce que** la saillie (17, 18) est conçue comme un nez d'appui et de support et/ou la saillie (17, 18) est en forme de coin et est adaptée à la taille de l'évidement central (7) de l'objet de préhension (4).

9. Outil de préhension selon la revendication 8, **caractérisé en ce que** la tige de réglage (19, 20) est montée sur la préhenseur (10) de manière à pouvoir tourner autour de son axe longitudinal et est reliée au dispositif de réglage (16).

10. Outil de préhension selon l'une des revendications 1, 3, 5, 6 ou 7, **caractérisé en ce que** le moyen de préhension (15) présente à son extrémité une saillie latérale (17, 18) qui est déplacée au moyen d'un engrenage à coin, d'un actionnement fluidique ou magnétique ou d'une autre manière, éventuellement contre un élément de rappel élastique.

11. Outil de préhension selon l'une des revendications précédentes, **caractérisé en ce que** le dispositif de réglage (16) présente un actionneur (22) pouvant être commandé avec un engrenage (23), de préférence conçu comme une crémaillère pour convertir un mouvement d'entraînement linéaire en un mouvement de rotation de la ou des tiges de réglage (19, 20) pour actionner une ou plusieurs tiges de réglage (19, 20) .

12. Outil de préhension selon l'une des revendications précédentes, **caractérisé en ce que** l'outil de préhension présente un dispositif d'avance (33) pour une courroie (6) disposée sur l'objet de préhension (4) .

13. Dispositif de préhension pour des objets de préhension (4) en forme de bobine et/ou de disque, en particulier des bobines SMD, le dispositif de préhension (1) comprenant un dispositif de manipulation (3) programmable, mobile dans un ou plusieurs axes et auquel est fixé un outil de préhension (2) selon la revendication 1.

14. Dispositif de préhension selon la revendication 13, **caractérisé en ce que** le dispositif de manipulation (3) comporte un système de capteurs (29) associé qui absorbe des charges externes.

15. Procédé pour saisir et manipuler un objet de préhension (4) en forme de bobine et/ou de disque, en particulier un rouleau CMS, au moyen d'un outil de préhension (2), l'outil de préhension (2) étant manipulé et actionné automatiquement par un dispositif de manipulation (3) programmable, déplaçable dans un ou plusieurs axes, l'objet de préhension (4) étant saisi et guidé de manière centrale par l'outil de préhension (2) avec un préhenseur (10) présentant un dispositif de réglage (16) pouvant être commandé, **caractérisé en ce que** la préhenseur (10) présente un bras de support (11, 12) avec un moyen de préhension (15) pouvant être commandé à l'extrémité, le moyen de préhension (15) pouvant être commandé présentant une tige de réglage (19, 20) s'étendant le long du bras de support (11, 12) avec une saillie latérale (17, 18) à l'extrémité et l'objet de préhension (4) étant en outre saisi et supporté, et éventuellement monté à rotation, au centre de son évidement central (7) par le moyen de préhension (15) pouvant être commandé.
